(19) Europäisches Patentamt
European Patent Office
Office européen des brevets

(11) **EP 4 492 478 A1**

(12) **EUROPEAN PATENT APPLICATION**

(43) Date of publication:
**15.01.2025 Bulletin 2025/03**

(21) Application number: **23185173.4**

(22) Date of filing: **13.07.2023**

(51) International Patent Classification (IPC):
**H01L 33/00** $^{(2010.01)}$

(52) Cooperative Patent Classification (CPC):
**H01S 5/142; H01S 5/1092;** H01S 3/083;
H01S 3/106; H01S 3/1062; H01S 5/02446

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Stichting IMEC Nederland
5656 AE Eindhoven (NL)**

(72) Inventor: **OLDENBEUVING, Ruud
5651 HE Eindhoven (NL)**

(74) Representative: **Roth, Sebastian
Mitscherlich PartmbB
Patent- und Rechtsanwälte
Karlstraße 7
80333 München (DE)**

(54) **A TUNABLE LASER WITH AN EXTERNAL CAVITY**

(57) The present disclosure relates to a tunable laser, in particular, an external cavity type laser. The disclosure also relates to a method of operating the tunable laser. The tunable laser of this disclosure is designed for fast and repeatable wavelength tuning over a wide wavelength range. The tunable laser comprises a cavity, a gain medium arranged in a region of the cavity, the gain medium being configured to generate light by stimulated emission and to emit the light into the cavity, and a laser output configured to output a portion of the light in the cavity as a laser beam. The cavity includes a first resonator and a second resonator that are optically coupled to each other, wherein a resonance frequency of the first resonator is tunable. A free spectral range (FSR) of the second resonator is an integer multiple of a FSR of the cavity.

**FIG. 1**

**Description**

TECHNICAL FIELD

The present disclosure relates to a tunable laser, in particular, an external cavity type laser. The disclosure also relates to a method of operating the tunable laser. The tunable laser of this disclosure is designed for fast and repeatable wavelength tuning over a wide wavelength range.

BACKGROUND

In integrated photonics, in order to design a tunable laser, it becomes increasingly more important to integrate a suitable light source, for instance a laser diode, into a photonic integrated circuit (PIC). Tuning the spectral properties, such as wavelength, wavelength agility, spectral linewidth, coherence length, relative intensity noise, etc., of the laser, can be done via the proper design and fabrication of an additional external cavity in the said PIC.

An example of such an external cavity comprises a set of tunable resonators, for instance, a set of two or more coupled ring resonators of slightly different circumferences. The external cavity with these tunable ring resonators can be coupled to, for example, a linear resonator or cavity of the light source, for example the laser diode, which contains a gain medium.

The external cavity allows making use of the well-known Vernier effect, which can effectively increase the tunability of the laser, while decreasing the linewidth and further enhancing the spectral purity.

However, there is still a need to improve such integrated external cavity lasers and, in particular, to find new designs for external cavities.

SUMMARY

The solution of the present disclosure is based further on the following considerations.

In the above-described type of external cavity laser, the wavelength tuning is typically done via a relatively slow mechanism, such as phase tuning of the various resonators with phase shifters, for instance, heaters. By phase tuning the resonators, predefined laser wavelengths can be addressed.

For example, by tuning the phase of a first ring resonator of the external cavity, so as to first address lower wavelengths before moving to higher wavelengths, the resonant modes of a second (not tuned, i.e., stationary) ring resonator can be addressed as well. However, for each wavelength, the phase of the linear resonator needs to be tuned as well, in order to ensure that the wavelength fits inside the entire cavity of the laser and thus to avoid a power loss. This means that the speed of the phase shifter for the linear resonator is a bottleneck in terms of the overall tuning speed of the laser. As a consequence, the aforementioned switching scheme, from the lowest to the highest wavelength of the first ring resonator, cannot be practically addressed.

In view of this, the present disclosure aims to provide an improved tunable laser with an external cavity. An objective is, in particular, to provide a tunable laser, which can be tuned fast without experiencing power loss. A particular objective is to circumvent the above-described bottleneck of needing to tune a phase shifter of a linear resonator, when implementing the scheme of tuning a first resonator while keeping a second resonator stationary.

These and other objectives are achieved by the solution of this disclosure that is provided in the independent claims. Advantageous implementations are described in the dependent claims.

A first aspect of this disclosure provides a tunable laser comprising: a cavity; a gain medium arranged in a region of the cavity, the gain medium being configured to generate light by stimulated emission and to emit the light into the cavity; and a laser output configured to output a portion of the light in the cavity as a laser beam; wherein the cavity includes a first resonator and a second resonator that are optically coupled to each other, wherein in a resonance frequency of the first resonator is tunable; and wherein a free spectral range (FSR) of the second resonator is an integer multiple of a FSR of the cavity.

Because the FSR of the second resonator is matched in the above-described way to the FSR of the entire cavity of the tunable laser, the first resonator can be tuned while the second resonator is kept stationary, and no power loss occurs even without operating any other phase shifter. Thus, only the first resonator needs to be tunable in the laser of the first aspect. The tunable laser can moreover be tuned fast without experiencing the power loss. The design of the second resonator and the cavity of the laser allows circumventing the above-described bottleneck of a phase shifter of a linear resonator that has to be tuned, when tuning the first resonator and keeping the second resonator stationary.

The gain medium may, for example, be based on semiconductor material of a semiconductor laser diode. The laser diode may comprise the region of the cavity where the gain medium is located. The resonators may form an external cavity coupled to the laser diode. The laser diode and the external cavity may be integrated on a PIC.

In an implementation of the laser, the cavity includes a linear resonator, the gain medium is arranged in a region of the linear resonator, and the linear resonator is optically coupled to the first and the second resonator.

The gain medium and the linear resonator may, for instance, form the laser diode. The laser diode may be coupled to the external cavity including the first and the second resonator. The resulting tunable laser maybe a hybrid external cavity laser.

In an implementation of the laser, the linear resonator is optically coupled to the first and the second resonator by an optical splitter; and the optical splitter is configured to allow light to couple from the linear resonator into the first and the second resonator and to allow light to couple from the first and the second resonator into the linear resonator.

In an implementation of the laser, the optical splitter is further optically coupled to the laser output.

In an implementation of the laser, a resonance frequency of the linear resonator is tunable.

That is, the linear resonator can be tunable in the laser of the first aspect, but this is not a requirement. While the tunability of the linear resonator may enhance the tunability of the laser as a whole, it is not required for the wavelength tuning scheme that is described above. The tunability of the linear resonator maybe useful for defining the tunable wavelength range of the laser, for instance, by setting a starting point.

In an implementation of the laser, a resonance frequency of the second resonator is tunable.

That is, the second resonator can be tunable in the laser of the first aspect, but this is not a requirement. While the tunability of the second resonator may enhance the tunability of the laser as a whole, it is not required for the wavelength tuning scheme described above, in particular, since the second resonator is anyhow kept stationary in this scheme.

In an implementation of the laser, the laser further comprises one or more phase shifters; wherein a first phase shifter of the one or more phase shifters is configured to tune the resonance frequency of the first resonator.

In an implementation of the laser, a second phase shifter of the phase shifters is configured to tune the resonance frequency of the second resonator; and/or a third phase shifter of the phase shifters is configured to tune the resonance frequency of the linear resonator.

In an implementation of the laser, at least one of the resonance frequency of the second resonator and the resonance frequency of the linear resonator is not tunable.

In an implementation of the laser, the first resonator is a first ring resonator and/or the second resonator is a second ring resonator.

The first and the second resonator can alternatively be Mach-Zehnder-Interferometers, or Fabry-Perot-Interferometers, or similar kinds of resonators.

In an implementation of the laser, the first ring resonator has a different circumference than the second ring resonator.

This leads to different resonance frequencies of the ring resonators and thus enhances the tunability of the laser.

In an implementation of the laser, the cavity includes one or more additional resonators, which are optically coupled to each other and to the first and the second resonator.

In an implementation of the laser, a resonance frequency of at least one of the additional resonators is tunable.

The one or more additional resonators contribute to the entire cavity, and thus the FSR of the entire cavity.

A second aspect of this disclosure provides a method for operating a tunable laser system of the first aspect or any of its implementations, wherein the method comprises: tuning the resonance frequency of the first resonator; and keeping the resonance frequency of the second resonator fixed, while tuning the resonance frequency of the first resonator.

In an implementation of the method, tuning the resonance frequency of the first resonator produces a plurality of peaks in power of the laser beam output by the laser output, wherein the power of each peak is equal.

The method of the second aspect achieves the same advantages as the tunable laser of the first aspect, and may be extended by respective implementations as described above for the tunable laser of the first aspect. The method allows tuning the laser without power loss and with increased speed compared to a similar laser, which does not have the FSR of the second resonator matched to the FSR of the cavity.

In summary of the above aspects and implementations, this disclosure provides a fast-tunable external cavity laser with a set of resonators, for instance ring resonators, in an external cavity. The preferred tuning scheme works by tuning a first resonator of the set of resonators from a lowest to highest wavelength, while keeping a second resonator (and optionally one or more additional resonators) of the set of resonators stationary. The tunable laser is based on a specific cavity design, according to which the FSRs of the second resonator and the entire cavity of the laser are matched as described above, in order to enable the fast tunability.

## BRIEF DESCRIPTION OF THE DRAWINGS

The above described aspects and implementations are explained in the following description of embodiments with respect to the enclosed drawings:

FIG. 1    shows a tunable laser according to this disclosure.

FIG. 2    shows a tunable laser according to this disclosure with two ring resonators and a linear resonator

FIG. 3    shows a tunable laser according to this disclosure with two ring resonators, a linear resonator, and three phase shifters.

FIG. 4    show filter responses when tuning a first ring resonator or a second ring resonator on their own, or when tuning coupled ring resonators.

FIG. 5    shows filter responses of various settings when tuning two or more ring resonators of a tunable laser according to this disclosure.

FIG. 6 shows a laser out power when tuning the first resonator and keeping the second resonator stationary of (a) an exemplary laser and (b) a laser according to this disclosure.

FIG. 7 shows a method of operating a tunable laser according to this disclosure.

## DETAILED DESCRIPTION OF EMBODIMENTS

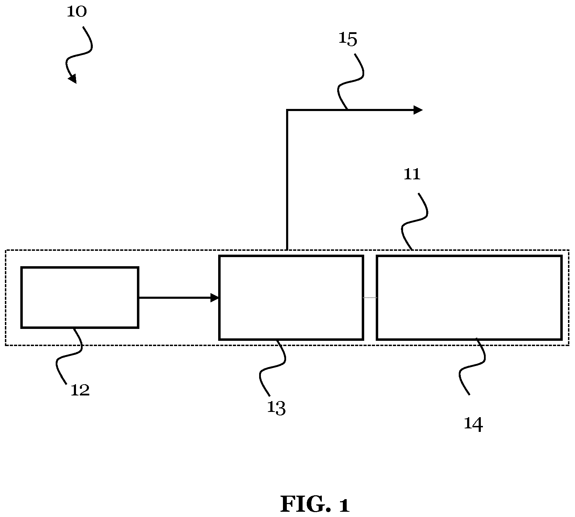

FIG. 1 shows a tunable laser 10 according to this disclosure. The tunable laser 10 comprises a cavity 11, wherein the cavity 11 comprises at least a first resonator 13 and a second resonator 14. The tunable laser 10 may be referred to as an external cavity tunable laser, wherein the cavity 11 includes one or more external components - in this case the first and the second resonator 13, 14 that may form the external cavity - to enable a greater control over the spectral properties of a laser beam that is generated by the tunable laser 10.

The laser 10 comprises a gain medium 12, which is arranged in a region of the cavity 11. The gain medium 12 is configured to generate light by stimulated emission, and to emit the generated light into the cavity 11. The gain medium 12 may not be distributed throughout the entire cavity 11. For instance, the gain medium 12 may be not arranged in the external cavity, which provides an optical path for the emitted light that extends beyond the immediate region that houses the gain medium 12. The region housing the gain medium 12 may be a linear resonator, for instance an internal cavity of a laser diode, which may be coupled to the first and the second resonator 13, 14 being part of the external cavity.

The laser 10 also comprises a laser output 15, which is configured to output a portion of the light in the cavity 11 as a laser beam. The light in the cavity 11 may be amplified by passing through the gain medium 12 on or multiple times and by constructive interference in the cavity 11, particularly, in the resonators 13, 14.

The first and the second resonator 13, 14 are optically coupled to each other, and a resonance frequency of at least the first resonator 13 is tunable. A resonance frequency of the second resonator 14 may also be tunable, but it may also be not tunable. Due to the tunability of at least the first resonator 13, which allows changing the properties of the cavity 11, the wavelength of the laser beam provided at the laser output 15 can be adjusted or "tuned".

The solution of this disclosure lies especially in the design of the second resonator 13 and the cavity 11, in particular, matching the second resonator 14 specifically to the cavity 11 as follows. According to the solution of this disclosure, a FSR of the second resonator 14 is an integer multiple of an FSR of the cavity 11 (i.e., the entire cavity 11 including the second resonator 14). Mathematically this can be described by the following Equation (1):

$$\Delta v_r = n \cdot \Delta v_{tot} \qquad (1)$$

In this equation, $\Delta v_r$ is the FSR of the second resonator 14 (in Hz), $\Delta v_{tot}$ is the FSR of the entire laser cavity 11 (in Hz), and n is a positive integer number larger than zero. Notably, the FSR may denote the distance between adjacent resonance peaks, as explained below.

The benefits of this design of the laser 10, especially of the matched FSRs of the second resonator 14 and the cavity 11, are described in more detail in the following. Thereby, an example of the tunable laser 10 with specifically two ring resonators as the first and the second resonator 13, 14 is used. However, the solution of this disclosure is not limited to the use of such ring resonators. The first and the second resonator 13, 14 could, respectively, be a Mach-Zehnder-Interferometer, or a Fabry-Perot-Interferometer, or the like.

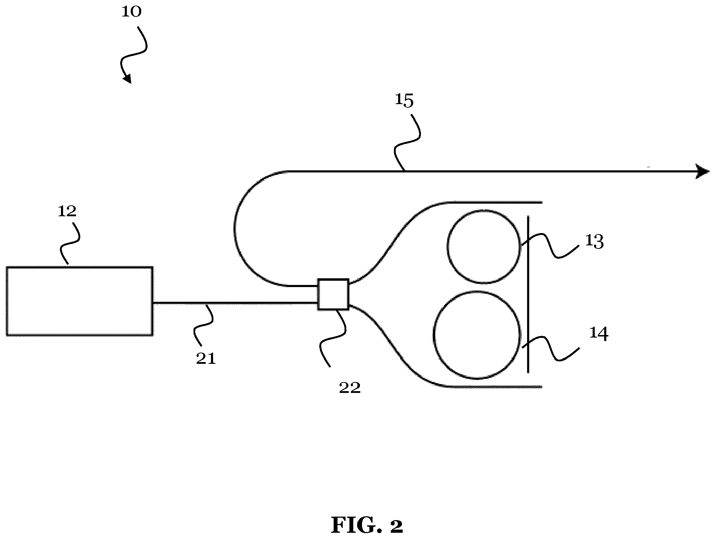

FIG. 2 shows a tunable laser 10 according to this disclosure with at least two ring resonators, which builds on the tunable laser 10 shown in FIG. 1. The tunable laser 10 shown in FIG. 2 has a first ring resonator 13 and a first ring resonator 14 that are part of an external cavity.

FIG. 2 shows that the layout of the laser 10 comprises a gain region, in which the gain medium 12 is contained (left-hand side), and shows waveguides defining the rest of the cavity 11 (on the right-hand side). The cavity 11 may include a linear resonator 21, for instance, of a laser diode, and the gain medium 12 may be arranged in a region of this linear resonator 21. The linear resonator 21 may be an internal cavity, for instance, of the laser diode. The linear resonator 21 is optically coupled to the external cavity comprising at least the first and the second ring resonator 13, 14. For instance, the linear resonator 21 may be coupled to the two ring resonators 13, 14 by an optical splitter 22, which is configured to allow light to couple from the linear resonator 21 into the first and the second ring resonator 13, 14, respectively, and also to allow light to couple from the first and the second ring resonator 13, 14, respectively, into the linear resonator 21.

As shown by the schematic illustration of the tunable laser 10 in FIG. 2, the first ring resonator 13 and the second ring resonator 14 may have different circumferences. The laser output 15, which is configured to output the laser beam, is also shown, and is coupled to the optical splitter 22.

Notably, the solution of this disclosure is not limited to this exact scheme, even in case of using ring resonators 13, 14. For instance, the cavity 11 could include one or more additional (e.g., ring) resonators, which may be optically coupled to each other and to the first and the second resonator 13, 14. In an example, a resonance frequency of at least one of these additional resonators may be tunable.

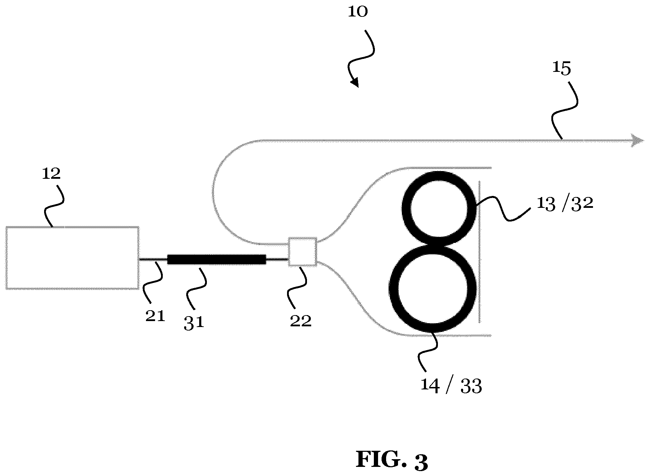

In the tunable laser 10 shown in FIG. 2, the wavelength tuning may be caused by tuning at least the first ring resonator 13, which may be implemented with a phase shifter. For example, as shown in FIG. 3, the tunable laser 10 may comprises one or more phase shifters 31, 32, 33. A first phase shifter 32 may be arranged and configured to tune the resonance frequency of the first resonator 13. The first phase shifter 32 may be the only phase shifter of the tunable laser 10, i.e., the laser 10 may comprise only a single phase shifter 32 to tune the first resonator 13. In this case, the resonance frequency of the second resonator 14 and the resonance frequency of a potential linear resonator 21 are not tunable.

However, as illustrated in FIG. 3 for ease of understanding all possible implementation of the tunable laser 10, the laser 10 may also comprise a second phase shifter 33, which may be arranged and configured to tune the resonance frequency of the second resonator 14. The laser 10 may also comprise a third phase shifter 31, which maybe arranged and configured to tune the resonance frequency of the linear resonator 21. In other words, at least one of the resonance frequency of the second resonator 14 and the resonance frequency of the linear resonator 21 is tunable as well. The (typical) locations of the phase shifters 31, 32, 33 are indicated in FIG. 3 with the thicker black lines.

Each phase shifter 31, 32, 33 may be or comprise a heater, i.e., the tuning of the various resonator(s) of the laser 10 may be done with heaters. Other phase shifters 31, 32, 33 and phase shifting mechanisms may be used as well, for instance, using stress to change a refractive index of the resonators or using liquid crystal technology. By phase tuning at least the first ring resonators 13, predefined wavelengths of the laser 10 can be addressed.

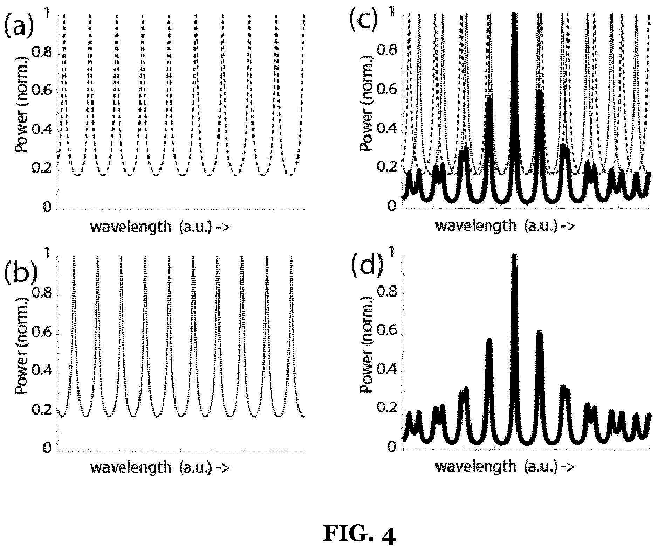

FIG. 4(a) shows a filter response (power vs. wavelength) of an exemplary first ring resonator 13 and FIG. 4(b) shows a filter response of the exemplary second ring resonator 14. Combining these filter responses gives a frequency response as shown in FIG. 3(d), while all three filter responses are overlaid in FIG. 3(c).

An important parameter of the spectral response of a resonator is the so-called the FSR. The FSR is defined as the distance between adjacent resonant frequencies of the resonator. FIG. 4(a), for example, shows that the FSR of the first ring resonator 13 is from peak-to-peak. Note that the FSR of the ring resonators 13 and 14 are slightly different in FIG. 4. When the two ring resonators 13 and 14 are combined in series (as is the case in FIG. 2 and FIG. 3), the combined filter response is that of the thick line in FIG. 3(c) and 3(d). In FIG. 3(c) the large dotted line represents the filter response of the second ring resonator 14, and the small dotted line represents the filter response of the first ring resonator 13.

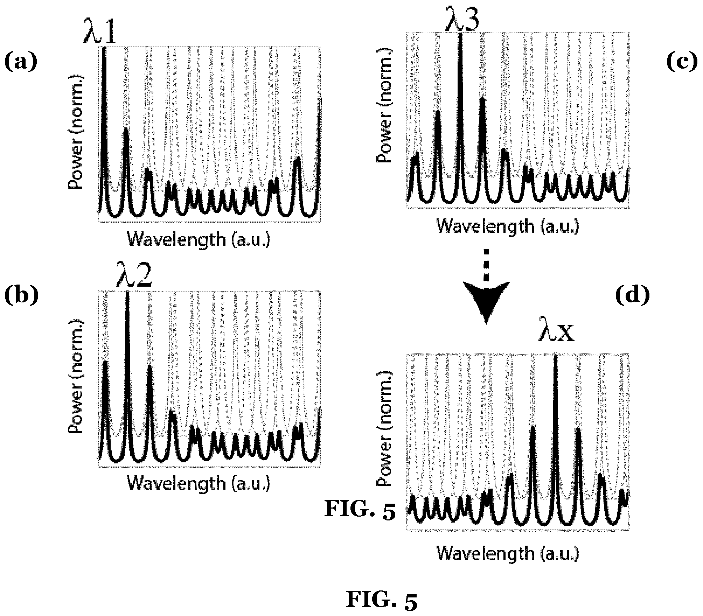

The tunable laser 10 of this disclosure may be operated according to a tuning scheme, wherein the first ring resonator 13 is tuned over 2 pi, while the second ring resonator 14 is kept stationary (i.e., is not tuned, regardless of whether it is tunable or not). While tuning in this way, the combined filter response moves over the entire spectrum, thus addressing all peaks of the second ring resonator 14. A few of the resulting spectra corresponding to different settings during the tuning are depicted in FIG. 5. The small-dotted line moves towards the right-hand-side of the graphs when looking first at $\lambda 1$ in FIG. 5(a), then at $\lambda 2$ in FIG. 5(b), then at $\lambda 3$ in Fig 5(c), and finally at $\lambda x$ in FIG. 5(d). The arrow between FIG. 5(c) and FIG. 5(d) indicates that the sequence $\lambda 1$, $\lambda 2$, $\lambda 3$ is followed equally until reaching $\lambda x$. A 2 pi phase shift will have occurred when the frequency response looks like $\lambda 1$ again.

When the spectrum shown exemplarily in FIGs. 4 and 5 is fed back into the gain region, i.e., to the gain medium 12 of the laser 10 shown in FIG. 2, a laser beam is emitted when there is enough coherent buildup of light inside the cavity 11. This is the case when an integer number of waves fit inside the cavity 11, causing constructive interference. If the wavelength becomes slightly larger, the constructive interference may still present inside the cavity 11, but not as pronounced, which leads to a lower laser output. When the wavelength is sufficiently larger, destructive interference may even be dominant and (almost) no coherent light will be emitted from the laser 10 in this case. This can be measured by a significant decrease in the laser output power, but also when looking at the spectrum of the output of the laser 10 (a loss of the laser-line).

If in the tunable laser 10, the FSR of the second ring resonator 14 would not be an integer multiple of the FSR of the cavity 11, then the above wavelength tuning scheme would have to be done as follows. When tuning the first resonator 13 from the lowest to the highest wavelength, in order to address each wavelength of the second resonator 14, the wavelengths would not necessarily all fit into the cavity 11. Thus, the phase shifter of the linear resonator 21 would have to be operated in addition, in order to tune the linear resonator 21 and thereby ensure that the wavelength fits. That is, the wavelength tuning scheme would be performed setting-to-setting. When using a typical type of phase shifter, like a heater, this would result in a rather slow tuning mechanism. Because the tuning is not instantaneous, a certain time would be needed each time until a steady state is reached. In other words, the wavelength tuning would be very slow and nearly impracticable.

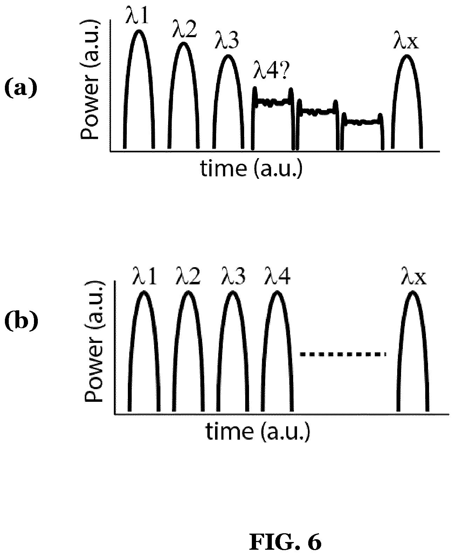

However, not tuning the linear resonator 21 would result in power loss. FIG. 6 compares in this respect a laser 10 of this disclosure and an exemplary laser. The laser 10 is shown in FIG. 6(b), and has the FSR of the second ring resonator 14 designed to be an integer multiple of the FSR of the cavity 11. The exemplary laser is shown in FIG. 6(a) and is mostly similar to the laser 10, but does not have the FSR of the second ring resonator 14 matched to the FSR of the cavity 11. In both cases, the switching from the lowest wavelength λ1 to a higher wavelength λx is measured by monitoring the output power of the laser vs. the time (during which the tuning mechanism is performed). In both cases only the first resonator 13 is tuned, and no other phase shifter is operated.

In FIG. 6(a), λ1 fits an integer number times in the laser cavity 11, causing constructive interference and coherent laser output. However, λ2 and λ3 already show a lower output power and where λ4 should be, a non-coherent output with low power is seen. When the wavelength of the external cavity 11 is tuned even further, at a certain moment the next integer number of wavelengths will fit inside the cavity 11 again, causing a sudden increase in output power and coherence (depicted as λx).

In FIG. 6(b), due to the design of the laser 10 of this disclosure, such a drop is not observed. Notably, in the exemplary laser of Fig. 6(a), the drop in output power and decrease in coherence could be solved by tuning the linear resonator 21. In this case, the output power over time may even look like in FIG. 6(b). However, because the third phase shifter 31 is a physical phase shifter, which requires a larger-than 2 pi phase shift to address the different wavelengths imposed by a 2 pi phase shift of the ring resonator 13, the speed of wavelength tuning would be quite limited by the tuning speed of the third phase shifter 31. A fast tuning over the entire spectrum is not possible.

The laser 10 of this disclosure does not require such tuning the linear resonator 21 - in fact it does thus not require a tunable linear resonator 21 at all - to tune the laser 10 with high speed the preferred measurement shown in FIG. 6(b), where all wavelengths are addressed at equal power over the entire tuning range. The laser 10 of this disclosure thus circumvents the previously described bottleneck of continuously having to tune the linear resonator 21 to allow for equal laser power.

The relevance of the FSR can be explained as follows. To make sure that the required constructive interference occurs, an equal number of waves needs to fit inside the cavity 11. The wavelength difference between these wavelengths is the FSR of the cavity 11. All wavelengths that fit inside the cavity 11 (matching the wavelengths of the FSR of the cavity 11) are so-called cold cavity modes. For a ring resonator, like the second ring resonator 14, such cavity modes exist as well and have their own FSR. This FSR of the second ring resonator 14 is related to the circumference of the second ring resonator 14. The cold cavity modes of a laser with a set of at least two ring resonators as external waveguide circuit have a smaller FSR than the ring resonators themselves. By matching a multitude of the cold cavity mode spacing with the FSR of the stationary second ring resonator 14, all modes of the stationary ring resonator 14 that are addressed will be resonant for the entire laser. As already mentioned above, this FSR matching can be mathematically described by Equation (1).

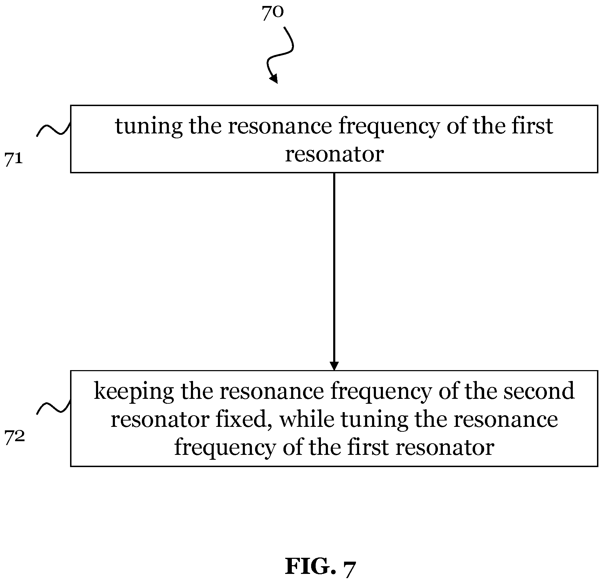

FIG. 7 shows a method 70 of operating the tunable laser 10 of this disclosure, as shown in FIG. 1 or FIG. 2. The method 70 comprises tuning 71 the resonance frequency of the first resonator 13, while keeping 72 the resonance frequency of the second resonator 14 fixed. Due to the design of the laser 10 and particularly the matching of the FSR of the second ring resonator 14 with the FSR of the cavity 11, the tuning of the resonance frequency of the first resonator 13 produces a plurality of peaks in power of the laser beam output by the laser output 15, wherein the power of each peak is equal, as shown in FIG. 6(b).

In summary, by matching the second ring resonator 14 to the cavity 11 regarding their FSRs, all peaks of the second resonator 14 can be addressed by tuning the first resonator 13 without a drop in power. Therefore, tuning other parts of the cavity 11, like the linear resonator 21, can be omitted and the speed of the tuning can thus be significantly increased.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A tunable laser (10) comprising:

   a cavity (11);
   a gain medium (12) arranged in a region of the cavity (11), the gain medium (12) being configured to generate light by stimulated emission and to emit the light into the cavity (11); and
   a laser output (15) configured to output a portion of the light in the cavity (11) as a laser beam;
   wherein the cavity (11) includes a first resonator (13) and a second resonator (14) that are optically coupled to each other, wherein a resonance frequency of the first resonator (13) is tunable; and
   wherein a free spectral range, FSR, of the second resonator (14) is an integer multiple of a FSR of the cavity (11).

2. The laser (10) of claim 1, wherein the cavity (11) includes a linear resonator (21), the gain medium (12) is arranged in a region of the linear resonator (21), and the linear resonator (21) is optically coupled to the first and the second resonator (13, 14).

3. The laser (10) of claim 1 or 2, wherein:

the linear resonator (11) is optically coupled to the first and the second resonator (13, 14) by an optical splitter (22); and

the optical splitter (22) is configured to allow light to couple from the linear resonator (21) into the first and the second resonator (13, 14) and to allow light to couple from the first and the second resonator (13, 14) into the linear resonator (21).

4. The laser (10) of claim 3, wherein the optical splitter (22) is further optically coupled to the laser output (15).

5. The laser (10) of claim 3 or 4, wherein a resonance frequency of the linear resonator (21) is tunable.

6. The laser (10) of one of the claims 1 to 5, wherein:

a resonance frequency of the second resonator (14) is tunable.

7. The laser (10) of one of the claims 1 to 6, further comprising:

one or more phase shifters (31, 32, 33); wherein a first phase shifter (32) of the one or more phase shifters (31, 32, 33) is configured to tune the resonance frequency of the first resonator (13).

8. The laser (10) of claim 7 and of claim 5 or 6, wherein:

a second phase shifter (33) of the phase shifters (31, 32, 33) is configured to tune the resonance frequency of the second resonator (14); and/or a third phase shifter (31) of the phase shifters (31, 32, 33) is configured to tune the resonance frequency of the linear resonator (21).

9. The laser (10) of one of the claims 1 to 8, wherein at least one of the resonance frequency of the second resonator (14) and the resonance frequency of the linear resonator (21) is not tunable.

10. The laser (10) of one of the claims 1 to 9, wherein the first resonator (13) is a first ring resonator and/or the second resonator (14) is a second ring resonator.

11. The laser (10) of claim 10, wherein the first ring resonator (13) has a different circumference than the second ring resonator (14).

12. The laser (10) of one of the claims 1 to 11, wherein: the cavity (11) includes one or more additional resonators, which are optically coupled to each other and to the first and the second resonator (13, 14).

13. The laser (10) of claim 12, wherein a resonance frequency of at least one of the additional resonators is tunable.

14. A method (70) for operating a tunable laser (10) of one of the claims 1 to 13, wherein the method (70) comprises:

tuning (71) the resonance frequency of the first resonator (13); and keeping (72) the resonance frequency of the second resonator (14) fixed, while tuning (71) the resonance frequency of the first resonator (13).

15. The method (70) of claim 14, wherein tuning the resonance frequency of the first resonator (13) produces a plurality of peaks in power of the laser beam output by the laser output (15), wherein the power of each peak is equal.

FIG. 1

FIG. 2

EP 4 492 478 A1

FIG. 3

**FIG. 4**

EP 4 492 478 A1

(a) λ1

(b) λ2

(c) λ3

(d) λX

FIG. 5

**FIG. 5**

FIG. 6

70

71 ~ tuning the resonance frequency of the first resonator

72 ~ keeping the resonance frequency of the second resonator fixed, while tuning the resonance frequency of the first resonator

**FIG. 7**

EP 4 492 478 A1

14

EP 4 492 478 A1

## EUROPEAN SEARCH REPORT

Europäisches
Patentamt

European
Patent Office

Office européen
des brevets

**Application Number**

EP 23 18 5173

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/131342 A1 (VAN REES ALBERT [NL] ET AL) 28 April 2022 (2022-04-28) * paragraph [0081] * ----- | 1-15 | INV. H01S5 |
| A | US 2019/027899 A1 (KRISHNAMOORTHY ASHOK V [US] ET AL) 24 January 2019 (2019-01-24) * paragraph [0043] – paragraph [0044]; figure 1A * ----- | 1-15 | |
| A | CN 113 557 643 A (NEOPHOTONICS CORP) 26 October 2021 (2021-10-26) * abstract; figure 2 * ----- | 1-15 | |

**TECHNICAL FIELDS
SEARCHED      (IPC)**

H01S

The present search report has been drawn up for all claims

| Place of search | Date of completion of the search | Examiner |
|---|---|---|
| Munich | 8 December 2023 | Flierl, Patrik |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.................................................................

& : member of the same patent family, corresponding
    document

EPO FORM 1503 03.82 (P04C01)

15

## ANNEX TO THE EUROPEAN SEARCH REPORT
## ON EUROPEAN PATENT APPLICATION NO.

EP 23 18 5173

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2023

| Patent document cited in search report | Publication date | Patent family member(s) | Publication date |
|---|---|---|---|
| US 2022131342 A1 | 28-04-2022 | CN 113316876 A | 27-08-2021 |
| | | EP 3912236 A1 | 24-11-2021 |
| | | KR 20210113362 A | 15-09-2021 |
| | | US 2022131342 A1 | 28-04-2022 |
| | | WO 2020148656 A1 | 23-07-2020 |
| US 2019027899 A1 | 24-01-2019 | US 2019027898 A1 | 24-01-2019 |
| | | US 2019027899 A1 | 24-01-2019 |
| CN 113557643 A | 26-10-2021 | CN 113557643 A | 26-10-2021 |
| | | EP 3931920 A1 | 05-01-2022 |
| | | JP 2022522796 A | 20-04-2022 |
| | | KR 20210125102 A | 15-10-2021 |
| | | TW 202105864 A | 01-02-2021 |
| | | US 2020280173 A1 | 03-09-2020 |
| | | WO 2020180728 A1 | 10-09-2020 |

EPO FORM P0459

For more details about this annex : see Official Journal of the European Patent Office, No. 12/82